# EUROPEAN PATENT SPECIFICATION

(11) **EP 3 429 045 B1**
(45) Date of publication and mention of the grant of the patent: **22.06.2022**
(21) Application number: 17290093.8
(22) Date of filing: 11.07.2017
(51) Int. Cl.: H02H 1/06, H02H 3/087, H01H 9/54, H01H 33/59, H02M 1/096, H03K 17/10

(54) **SELF-POWERED SWITCH DEVICE ADAPTED TO BE INCLUDED IN A MECHATRONIC CIRCUIT BREAKER AND METHOD FOR CONTROLLING THE SELF-POWERED SWITCH DEVICE**
SELBSTGESPEISTE SCHALTVORRICHTUNG, DIE ZUR EINFÜGUNG IN EINEN MECHATRONISCHEN SCHUTZSCHALTER ANGEPASST IST, UND VERFAHREN ZUR STEUERUNG DER SELBSTGESPEISTEN SCHALTVORRICHTUNG
DISPOSITIF DE COMMUTATION AUTOALIMENTÉ CONÇU POUR ÊTRE INCLUS DANS UN DISJONCTEUR MÉCATRONIQUE ET PROCÉDÉ DE COMMANDE DU DISPOSITIF DE COMMUTATION AUTOALIMENTÉ

(43) Date of publication of application: 16.01.2019
(73) Proprietor: General Electric Technology GmbH, 5400 Baden (CH)
(72) Inventor: Yang, Yang, 69100 Villeurbanne (FR); Grieshaber, Wolfgang, 69100 Villeurbanne (FR); Dupraz, Jean-Pierre, 75008 Paris (FR)
(74) Representative: Brevalex

(56) References cited:
- US-A- 5 455 758
- US-A1- 2017 178 832

## Description

### TECHNICAL FIELD

The invention generally relates to the field of high voltage mechatronic circuit breaker device.

More precisely, the invention relates to a self-powered switch device adapted to be included in a mechatronic circuit breaker device and to the method for controlling the self-powered switch device. The switches concerned by the present invention are high power switches requiring high electric energy to change their state. This type of switch comprises thyristor based switch and other controllable fast switches.

### PRIOR ART

US2017178832 A1 shows a breaker device for interrupting current flowing on a transmission line, the device comprising three electrical branches (B1, B2, B3) connected in parallel, including a main branch (B1) in which the current to be interrupted flows and an auxiliary branch (B2), the main branch comprising at least one semi-conductor breaker cell (CEL1) connected in series with at least one mechanical interrupter/disconnector (Sm), the auxiliary branch (B2) comprising at least one thyristor, the breaker device further comprising a control circuit (CM) suitable for interrupting a current that flows in the main branch.

US5455758 A shows a resonant power supply for use in conjunction with power transistor switching circuits. In one embodiment, a series-connected LC resonant circuit is coupled to the high voltage pulsed output of the power transistors and designed to draw power from the pulsed output and deliver the same to a low voltage output capacitor at which a low voltage output is provided.

As an example, EP 12 810 269 describes a mechatronic circuit breaker device able to break currents in a time less than a few milliseconds. A high voltage mechatronic circuit breaker device comprises at least a main branch, an auxiliary branch and an energy absorbing branch electrically connected in parallel.

The main branch includes a mechanical switch-disconnector and a fast switching apparatus switchable to selectively allow current to flow in the main branch in a normal mode of operation or commutate current from the main branch to the auxiliary branch in a switching-off mode of operation.

The auxiliary branch includes switching elements which can interrupt and commutate the current to the energy absorbing branch.

The energy absorbing branch limits the interruption voltage and absorbs the inductive energy until the current decreases to zero.

In the normal mode of operation of the mechatronic circuit breaker device, the mechanical switch-disconnector and the fast switching apparatus in the main branch are closed, and current from the electrical network flows in the main branch. Meanwhile the switching elements of the auxiliary branch are in OFF state, and little to no current flows through the auxiliary branch.

In the event of a fault occurring in the electrical network resulting in high fault current flowing in the main branch, the switching apparatus is opened to commutate the fault current from the main branch to the auxiliary branch.

Power electronics components are generally selected as switching elements in the auxiliary branch to interrupt a fault current. For example, thyristor with a fast turn-off time (Tq), GTO (Gate Turn-Off) thyristor and IGBT (Insulated Gate Bipolar Transistor) can all be used.

IGBT components have many advantages, such as high switching speed, low driver energy etc. However, their lower surge current rating multiplies the quantity of components to be used and increases the cost of the circuit-breaker.

In EP 12 810 269, thyristor type power electronic switches are used as switching elements in the auxiliary branch. A weak point of the thyristor based switches is their high driver energy for switching control.

In a mechatronic circuit-breaker, the switching elements are at a high voltage potential with respect to the ground. Providing the control driver energy for each switching element becomes a tough issue to resolve. A common solution is to power up the control driver of each switching element by a high voltage power supplier isolated from ground. The drawbacks are the complexity of ground supplier system and the isolation. For example, a power supply system isolated by transformer generally allows to hold a few kilovolts, but hardly holds a few tens of kilovolts.

EP 12 275 122 discloses a switching element in which a capacitive divider is connected in parallel with semiconductor switches. A low voltage capacitor in the capacitive divider is powered up with a positive voltage and provides the control driver energy of the switch. This device removes the ground supply system and is suitable for the IGBT components, which are voltage controlled switches and can switch OFF with a zero voltage between their control terminal (gate) and their cathode.

However, because numerous power electronic switches in series are necessary for meeting the voltage rating of mechatronic circuit breaker, the capacitance ratio between the low voltage ones and the high voltage ones should be high enough to get sufficient energy and the capacitive divider become voluminous. Moreover, to achieve turn-off control in GTO-based switches and other current controlled switches, the control driver of switches should be coupled to a source with a negative voltage with respect to the cathode of the switches.

The object of the invention is thus to propose a high voltage self-powered switch device adapted to be used in the auxiliary branch of a mechatronic circuit breaker apparatus that alleviates some or all the drawbacks of the above prior art.

Another object of the invention is to propose a control method for switching the self-powered switch device during operation of the mechatronic circuit breaker apparatus.

### STATEMENT OF THE INVENTION

To this end, the invention provides a self-powered switch device adapted to be included in a mechatronic circuit breaker characterized in that it comprises at least one self-powered switch module comprising:
- a switching device having main terminals adapted to be connected to a current path, and having a control terminal receiving a switching signal to selectively operate the switching device in a conductive state or a nonconductive state for controlling the conduction of current between the main terminals;
- a power supply circuit having first and second circuit terminals respectively connected to the main terminals of the switching device, a serial LCR circuit connected to the first circuit terminal, comprising an inductor, a first resistor and a first capacitor and a full wave rectifier circuit connected in series with the LCR circuit and the second circuit terminal; wherein the full wave rectifier circuit comprises a first and a second diode-capacitor circuits connected in parallel, the first diode-capacitor circuit having a positive diode and a positive storage capacitor connected in series and the second diode-capacitor circuit having a negative diode and a negative storage capacitor connected in series, the positive storage capacitor and the negative storage capacitor being both connected to the second circuit terminal; and
- a switch monitoring and driver module having an output connected to the control terminal of the switching device, two power terminals and a common terminal for receiving power connected in parallel with the positive storage capacitor and the negative storage capacitor respectively, and a signal terminal connected to a signal line to receive a control signal or send a switch state signal.

Due to the invention, it is possible to provide the driver energy to a turn-off switch with a device having a smaller volume than in the prior art. No pre-charged energy storage system is needed.

According to a preferred characteristic, the transient response of the LCR circuit in the power supply circuit is underdamped.

According to a preferred characteristic, the self-powered switch module comprises a first surge voltage limiter having two terminals respectively connected to the main terminals of the switching device.

According to a preferred characteristic, at the full wave rectifier circuit comprises a second surge voltage limiter and a third surge voltage limiter connected in parallel with the positive storage capacitor and the negative storage capacitor, respectively.

According to a preferred characteristic, the LCR circuit comprises a second resistor connected in parallel with the first capacitor.

According to a preferred characteristic, the switch monitoring and driver module is adapted to:
- provide a positive pulse of voltage or current between the control terminal and one of the main terminals of the switching device according to a received control signal using power from the positive storage capacitor;
- provide a negative pulse of voltage or current between the control terminal and one of the main terminals of the switching device according to a received control signal using power from the negative storage capacitor;
- send the information of voltages across the positive storage capacitor and/or the negative storage capacitor respectively, according to a received control signal.

According to alternative embodiment, the switching device comprises:
- a fast thyristor whose main terminals are an anode and a cathode, and of which the turn-off time is reduced by applying a negative pulse voltage between the control terminal and the cathode,
- a Gate Turn-Off thyristor,
- a gas insulated switch comprising an anode and a cathode, of which the anode current interruption is achieved by applying a negative pulse voltage between the control terminal and the cathode.

According to a preferred characteristic, the self-powered switch device comprises a plurality of self-powered switch modules connected in series.

According to a preferred characteristic, the self-powered switch device comprises two self-powered switch modules connected in antiparallel.

The invention also relates to a mechatronic circuit breaker device in which is included a self-powered switch device as previously presented, the mechatronic circuit breaker device comprising:
- a main branch having an electromechanical switch disconnector connected in series with two fast breaker cells arranged anti-series,
- an auxiliary branch connected in parallel with the main branch, having at least one auxiliary sub-branch, the auxiliary sub-branch comprising the self-powered switch device,
- an energy absorbing branch connected in parallel with the main branch and the auxiliary branch, and having at least one surge voltage limiter, and
- a breaker controller connected to the electromechanical switch disconnector, the fast breaker cells and each self-powered switch module by respective signal lines, and having a memory adapted to save the state information of each self-powered switch module.

The invention also relates to a switching control method of a self-powered switch device as previously presented, characterized in that it comprises steps of:
- sending a checking order to each self-powered switch module in the self-powered switch device;
- evaluating a switching criterion;
- sending a switching order to each self-powered switch module in the self-powered switch device;
wherein the step of sending a switching order is completed after every self-powered switch module in the self-powered switch device meets the switching criterion.

According to a preferred characteristic, a switching order comprises one of:
- a turn-on switching order when the self-powered switch device is in a blocking state; and
- a turn-off switching order when the self-powered switch device is in a conduction state.

According to a preferred characteristic, the switching criterion of a turn-on switching order comprises the voltage amplitude of the positive storage capacitor being higher than a first threshold, and the switching criterion of a turn-off switching order comprises the voltage amplitude of the negative storage capacitor being higher than a second threshold.

The invention also relates to a state checking method of a self-powered switch device included in a mechatronic circuit breaker as previously presented, which comprises steps of:
- sending an order for opening the fast breaker cells;
- sending a checking order to a self-powered switch module;
- evaluating a state criterion for the self-powered switch module;
- updating the state information of the self-powered switch module in the memory of the breaker controller; and
- sending an order for closing the fast breaker cells.

According to a preferred characteristic, the state criterion is evaluated using the voltage amplitude of the positive storage capacitor or the voltage amplitude of the negative storage capacitor.

### BRIEF DESCRIPTION OF THE DRAWINGS

Other advantages and features of the invention become more clearly apparent on reading the detailed description given with reference to the following figures, in which:
- Figure 1 shows an electrical architecture of a mechatronic circuit breaker device according to an embodiment of the invention;
- Figure 2 shows an electrical architecture of a self-powered switch module included in the device of figure 1, according to an embodiment of the invention;
- Figure 3a shows the control signals of switches used in the device of figure 1, as a function of time, according to an embodiment of the invention;
- Figure 3b shows the curve of the voltage between the terminals of the mechatronic circuit breaker device of figure 1, as a function of time, according to an embodiment of the invention;
- Figure 3c shows the curve of a current flowing in a power supply circuit included in the module of figure 2, as a function of time, according to an embodiment of the invention;
- Figure 3d shows the curves of voltages of two storage capacitors in the power supply circuit included in the module of figure 2, as a function of time, according to an embodiment of the invention;
- Figure 3e shows the curves of currents flowing in the device of figure 1, in an interruption operation as a function of time, according to an embodiment of the invention;
- Figure 4 shows a state checking method of a self-powered switch module included in the device of figure 1, according to an embodiment of the invention; and
- Figure 5 shows a switching control method of a self-powered switch device included in the device of figure 1, according to an embodiment of the invention.

### DETAILED DESCRIPTION OF PARTICULAR EMBODIMENTS

The invention relates to a power supplying device and a driver for controlling the switches in the auxiliary branch of a mechatronic circuit breaker and a method for controlling the switches.

All along the description "connected" means "electrically connected", "in series" means "electrically connected in series", "in parallel" means "electrically connected in parallel", "closed" means rendered electrically conductive, "open" means rendered electrically nonconductive.

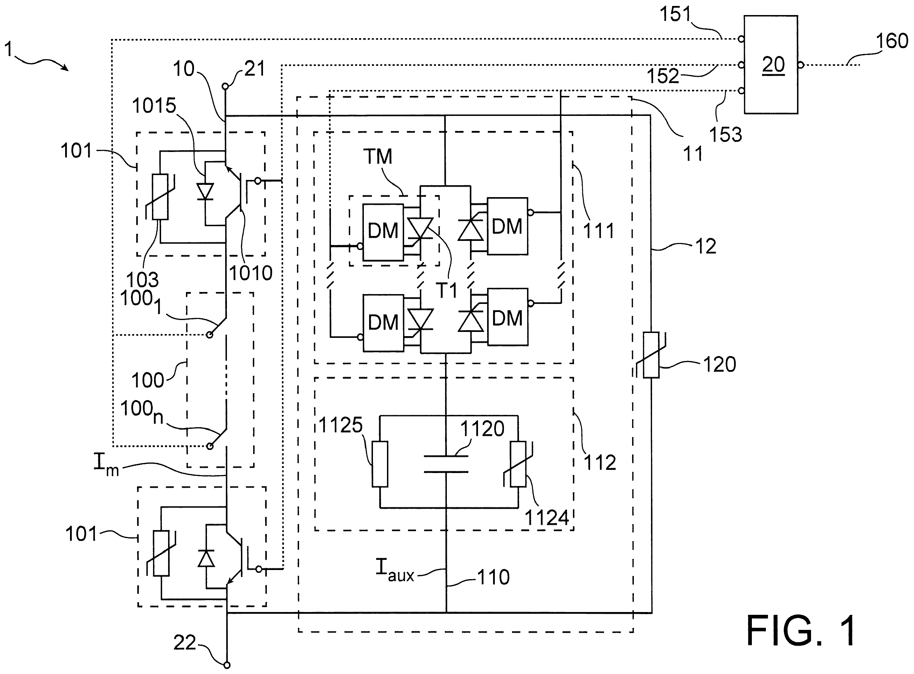

**Figure 1** shows an overall electrical architecture of a mechatronic circuit breaker device 1 intended to break a direct current in a high voltage direct current (HVDC) transmission network with a voltage for example higher than 20 kV. Only components essential to the present invention are described here.

The mechatronic circuit breaker device 1 has two terminals 21 and 22 connected to a power transmission link. The mechatronic circuit breaker device comprises a main branch 10, an auxiliary branch 11 and an energy absorbing branch 12.

When the main branch 10 of the mechatronic circuit breaker is closed, a supply power transmission link provides power to the fed power transmission link via the main branch 10. In other words, the main branch 10 is adapted for conducting a nominal load current to a fed power transmission link under normal operation conditions.

The main branch 10 comprises an electromechanical switch disconnector 100 consisting of a plurality of interrupters 100₁, ... 100ₙ, in series with two fast breaker cells 101, which are connected in anti-series and capable of interrupting the current in both directions. Each fast breaker cell 101 comprises at least one power electronic switch 1010 as for example an insulated gate bipolar transistor (IGBT).

Each fast breaker cell 101 comprises a diode 1015 in anti-parallel with the power electronic switch 1010, which bypasses the power electronic switch 1010 when a reverse voltage is applied on the power electronic switch 1010.

Each fast breaker cell 101 further comprises a surge voltage limiter 103 in parallel with the power electronic switch 1010. It is designed to limit the voltage to a value less than the withstand voltage of the power electronic switch 1010.

The auxiliary branch 11 is connected in parallel with the main branch 10. The auxiliary branch 11 is able to switch on to conduct a fault current flowing initially through the main branch 10 and interrupt this fault current after the opening of electromechanical switch disconnector 100 in the main branch 10. The auxiliary branch 11 comprises one auxiliary sub-branch 110 as shown in figure 1 or a plurality of auxiliary sub-branches 110 electrically in parallel with each other.

The auxiliary sub-branch 110 comprises a self-powered switch device 111 in the form of two self-powered switch module stacks arranged in antiparallel mode. A self-powered switch module stack comprises a plurality of self-powered switch modules TM in series.

Each self-powered switch module TM comprises a switching device T1 and a power supply and driver device DM. The switching device T1 comprises an anode, a cathode and a control terminal. The power supply and driver device DM is connected to the anode, the cathode and the control terminal of the switching device T1. The self-powered switch module TM is detailed in the following.

The switching device T1 may be a fast thyristor, which can be switched on by applying a positive pulse current between its gate (control terminal) and its cathode. The turn-off time (Tq) of this fast thyristor can be further optimized by applying a negative pulse voltage between its gate and its cathode.

The switching device T1 may be a Gate Turn-Off thyristor (GTO), which can be switched on by applying a positive pulse current between its gate and its cathode. It can further interrupt the anode current by applying a negative current between its gate and its cathode.

In another embodiment, the switching device T1 may be a gas insulated switch. The gas insulated switch comprises one or more electrode gaps that can be trigged on to conduct current. In an example of trigged spark gap switch, opposing electrodes may be spaced apart by a gas which is ionized when trigged to conduct current. The trigged spark gap switch may have at least one trigger electrode to initiate current conduction across the gap by applying a current or voltage pulse to initiate gas breakdown or ion/electron discharge from the electrodes.

The gas insulated switch may be a full control switch which is capable of interrupting the current conduction across the gap by applying an inverse polarized current or voltage pulse in the trigger electrode or control electrode.

The auxiliary sub-branch 110 also comprises, electrically in series with the self-powered switch device 111, a power capacitor module 112, which comprises a power capacitor 1120, itself electrically in parallel with a power resistor 1125.

The power capacitor 1120 and the power resistor 1125 are protected by an auxiliary surge voltage limiter 1124 connected in parallel with them. This surge voltage limiter 1124 is used for limiting the voltage that appears at the terminals of the auxiliary branch 11 when the current flows.

In an embodiment, the voltage rating of the power capacitor module 112 in each auxiliary sub-branch 110 may be different. The self-powered switch device 111 in each auxiliary sub-branch 110 may be switched on one after the other to commutate the transmission link current. This method can therefore generate a current zero in each auxiliary sub-branch 110 and finally interrupt the current.

In another embodiment, the configuration of the power capacitor module 112 in each auxiliary sub-branch 110 is identical and the voltage rating of the power capacitor module 112 is lower than the clamping voltage of the surge voltage limiter 103 of the main branch 10. All the auxiliary sub-branches 110 switch on at the same time and switch off the transmission link current simultaneously with a hard turn-off method. The power capacitor module 112 ensures the current balance between each auxiliary sub-branch 110 in a dynamic condition.

In still another embodiment, the auxiliary sub-branch 110 does not comprise the power capacitor module 112. In this case, the auxiliary sub-branch 110 only comprises the self-powered switch device 111.

The energy absorbing branch 12 is connected in parallel with the main branch 10 and the auxiliary branch 11. The branch 12 comprises one surge voltage limiter 120 or a plurality of surge voltage limiters in series and/or in parallel. Only one surge voltage limiter is represented in figure 1.

The surge voltage limiter(s) 120 is/are sized by the voltage rating of the transmission network in which the mechatronic circuit breaker device 1 is inserted and absorb(s) the inductive energy stored in transmission link when a fault current occurs.

The mechatronic circuit breaker device 1 further comprises a breaker controller 20 connected to the electromechanical switch disconnector 100 by a signal line 151 and to each power electronic switch 1010 of the fast breaker cells 101 by a signal line 152.

The breaker controller 20 is also connected to each self-powered switch module TM of the auxiliary branch 11 by a signal line 153, and the signal line 153 may be in duplex mode, by which the breaker controller 20 may send a signal and receive another signal.

Each power supply and driver device DM is configured to receive an instruction from the breaker controller 20 via the signal line 153 and further to send a state signal to the breaker controller 20 via the signal line 153.

The breaker controller 20 controls each self-powered switch device 111 in the mechatronic circuit breaker device 1 with a programmed method, for example, a switch turn-on, a switch turn-off and a state checking of a self-powered switch device 111 in the auxiliary branch 11.

The breaker controller 20 comprises a memory, in which the state information of each self-powered switch module TM may be saved. The state information of the self-powered switch module TM may be updated after each state checking process.

The breaker controller 20 is further connected to a transmission network control center (no shown) via a signal line 160. The breaker controller 20 is configured to receive instructions from the transmission network control center via the signal line 160. The breaker controller 20 is further configured to send state information of the self-powered switch module TM of the mechatronic circuit breaker device 1 to the transmission network control center via the signal line 160.

The breaker controller 20 may be in the form of an electronic circuit board, a computer or any other electronic device.

The mechatronic circuit breaker device 1 has three main modes of operation: conduction mode, interruption mode and closing mode.

Under steady conditions, i.e. in normal operation of the transmission network, the mechatronic circuit breaker works in the conduction mode: the fast breaker cells 101 and the electromechanical switch disconnector 100 of the main branch are in the ON (conducting) state, and a load current Iₘ passes through them and only in the main branch 10. The self-powered switch device(s) 111 in the auxiliary branch 11 is/are in a OFF state and the drivers of the self-powered switch device(s) 111 are not energized.

Most of the time, the mechatronic circuit breaker 1 works in the conduction mode. The current passes through the main branch 10 of the mechatronic circuit breaker 1 and a malfunction of the auxiliary branch 11 is difficult to detect. This decreases the reliability of the mechatronic circuit breaker 1.

In the case of malfunction of a self-powered switch module TM, for example, a power thyristor T1 fails short-circuit. Consequently, the power supply and driver device DM in parallel with this thyristor T1 may not be charged up and therefore cannot function properly.

According to a first aspect of the invention, the breaker controller 20 is adapted to receive a checking instruction and consequently to implement a state checking of the self-powered switch module TM of the auxiliary branch 11. The state checking of the self-powered switch module TM includes:
a) Open the fast breaker cells 101 via the signal line 152;
b) Send a checking order to the self-powered switch module TM in the auxiliary branch 11 via the signal line 153;
c) Check the state signal of the self-powered switch module TM received via the signal line 153.
d) Close the fast breaker cells 101 via the signal line 152.

In step a) the fast breaker cells 101 are triggered off by communicating a specific instruction or an order of opening to at least one power electronic switch 1010. The specific instruction or the order of closing is communicated from the breaker controller 20.

The load current of the transmission link is subsequently commutated to the surge voltage limiter 103. A step voltage is subsequently applied across the fast breaker cells 101 and each self-powered switch module TM in the self-powered switch device 111.

Step b) is executed after a predetermined delay corresponding to charging of the driver circuitry in the power supply and driver device DM.

The driver of each switching device T1 in the self-powered switch device 111 may be powered up and ready to function after this delay.

The power supply and driver device DM is configured to measure a power supply criterion of the driver circuitry which is a function of voltage amplitudes of two capacitor banks supplying the power of driver circuitry after the reception of the checking order.

The power supply and driver device DM further communicates the measurement results in a form of decodable signal back to the breaker controller 20 by the signal line 153.

For example, the power supply and driver device DM sends a predetermined signal to communicate that it fulfills the power supply criterion, or sends nothing in case of malfunction.

Step b) may be further executed several times during a predetermined time.

Checking of the state signal in step c) is initiated after the sending of checking order (step b). State signal checking process finishes in a predetermined delay time corresponding to the sum of the signals transmission times in the signal line 153 and instruction execution time of the power supply and driver device DM.

Based on the received state signal in step c) the breaker controller 20 can identify the state of the self-powered switch module TM in the auxiliary branch 11. For example, through the state information signal the breaker controller 20 can determine whether a self-powered switch module TM has failed.

Steps b) and c) are repeated for each self-powered switch module TM.

The state information of each self-powered switch module TM may be saved in the memory of the breaker controller 20, and the state information of each self-powered switch module TM may be updated after each checking process.

The breaker controller 20 may communicate the state information of the self-powered switch module(s) TM to another electronic device, and a suitable maintenance operation can be applied.

Step d) is initiated when the state signals checking is finished. The power electronic switch 1010 is triggered on, the load current commutates from the surge voltage limiter 103 to the power electronic switch 1010.

Step d) may be further initiated at the time at which the energy absorbed by the surge voltage limiter 103 exceeds its energy limit.

The second operation mode of the mechatronic circuit breaker device 1 is a current interruption.

For example, when the mechatronic circuit breaker device works in the conduction mode and a fault occurs in the network and causes a surge current, the breaker controller 20 is adapted to implement the following steps in order to interrupt the current by the mechatronic circuit breaker device 1.

e) Send a turn-off order via the signal line 152 to the fast breaker cells 101.

The fast breaker cells 101 execute subsequently the order to switch all the power electronic switches 1010 from ON state to OFF state. The voltage across the power electronic switches 1010 rises until it reaches the threshold voltage of the surge voltage limiters 103 that becomes conducting and prevents further voltage rise.

f) Send a turn-on order to at least one self-powered switch device 111.

A state checking of each self-powered switch module TM is first performed to ensure it is ready for closing. After each self-powered switch module TM meets the switching-on criterion, the breaker controller 20 sends a turn-on order to each self-powered switch module TM to switch on the self-powered switch device 111 and commutate the network current into the auxiliary branch 11.

g) Send an opening order to the electromechanical switch disconnector 100.

The electromechanical switch disconnector 100 receives the opening order and initiates its opening. Sometime later, the electromechanical switch disconnector 100 has completed opening and its withstand voltage has risen to a suitable level.

h) Send a turn-off order to the self-powered switch device 111.

A state checking of each self-powered switch module TM is firstly performed to ensure it is ready for opening. After each self-powered switch module TM meets the switching-off criterion, the breaker controller 20 sends a turn-off order to each self-powered switch module TM to switch the self-powered switch device 111 off. Consequently, the voltage across the auxiliary branch 11 increases.

The current in the auxiliary branch 11 commutates from the auxiliary branch 11 to the surge voltage limiter 120 when the voltage exceeds the clamping voltage of the surge voltage limiter 120 and the currents in the main and auxiliary branches become substantially zero.

The third operation mode of the mechatronic circuit breaker 1 is closing mode.

The breaker controller 20 is adapted to implement the following steps in order to close the mechatronic circuit breaker 1.

i) Send turn-on order to the self-powered switch device 111 of at least one auxiliary sub-branch 110.

j) Send turn-on order to the electromechanical switch-disconnector 100.

k) Send turn-on order to the fast breaker cells 101 after the electromechanical switch-disconnector 100 has completed the closing.

In interruption mode and closing mode, a control of availability of the self-powered switch device 111 is an essential action. Before operating a self-powered switch device 111, a fast state checking for each self-powered module TM increases the reliability of the mechatronic circuit breaker device 1.

According to a second aspect of the invention, the breaker controller 20 is adapted to implement the following steps in order to control the switching of a self-powered switch device 111 in a mechatronic circuit-breaker device 1, after the reception of a switching instruction. The switching instruction may be an instruction to order a self-powered switch device 111 to turn on or to turn off.

l) Send a checking order to each self-powered switch module TM of the self-powered switch device 111 via the signal line 153.

m) Check the state signals of the self-powered switch modules TM received via the signal line 153.

n1) If all the state signals of the self-powered switch modules TM meet the switching criterion corresponding to the switching instruction, send simultaneously a switching order to each self-powered switch module TM via the signal line 153.

n2) if the state signal of at least one self-powered switch module TM does not meet the switching criterion corresponding to the switching instruction, perform step 1) after a delay time.

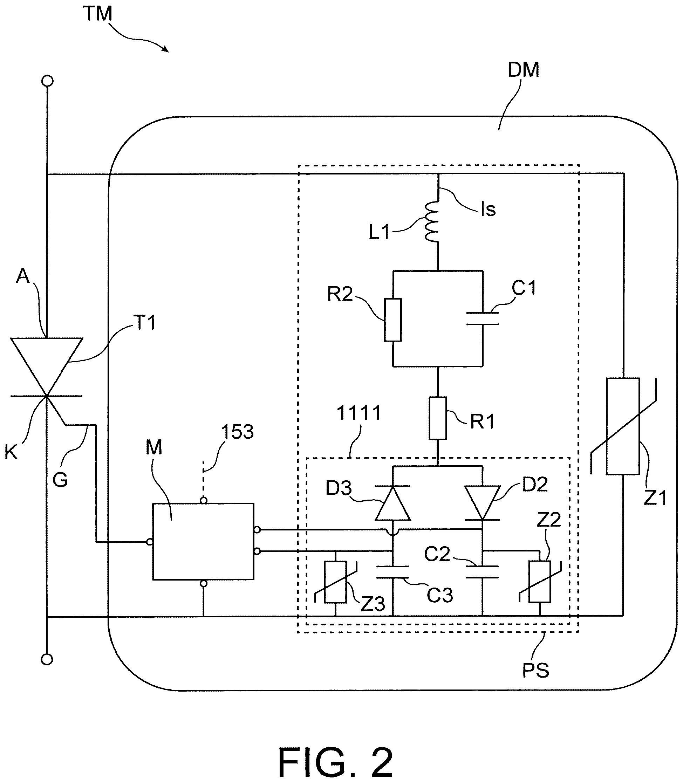

**Figure 2** shows an electrical architecture of a self-powered switch module TM, according to an embodiment of the invention.

The switching device T1 is one of the plurality of switching devices in the auxiliary branch 11 of the mechatronic circuit breaker device as shown in figure 1. The switching device T1 is classically provided with three terminals: an anode A and a cathode K acting as main terminals and a control terminal G acting as a gate.

The power supply and driver device DM comprises:
- A power supply circuit PS comprising first and second circuit terminals connected to the anode A and the cathode K of the switching device T1, respectively, and a L-C-R circuit comprising an inductor L1, a resistor R1, and a first capacitor C1 in series and connected with the first circuit terminal and in series with a full wave rectifier circuit 1111 connected to the second circuit terminal. The LCR circuit further comprises a second resistor R2 in parallel with the first capacitor C1. The full wave rectifier circuit 1111 comprises two branches in parallel. The first branch comprises a positive diode D2 connected in series to a positive storage capacitor C2 and connected anti-parallel to the second branch comprising a negative diode D3 and a negative storage capacitor C3. The positive storage capacitor C2 and the negative storage capacitor C3 are connected to the second circuit terminal. The full wave rectifier circuit 1111 further comprises a positive surge voltage limiter Z2 and a negative surge voltage limiter Z3 in parallel with the positive storage capacitor C2 and the negative storage capacitor C3, respectively.
- A surge voltage limiter Z1 in parallel with the switching device T1.

According to the power supply circuit PS the transient response of the LCR circuit may be underdamped.

A switch monitoring and driver module M is connected to the gate G and the cathode K of the switching device T1 and connected to the positive storage capacitor C2 and the negative storage capacitor C3, respectively, and further connected to the breaker controller 20 by the signal line 153.

Upon reception of the different orders from the breaker controller 20 via the signal line 153, the module M is adapted to:
- After reception of a checking order, measure the voltage amplitudes across the storage capacitors C2 and/or C3, and send the voltage information to the breaker controller 20 via the signal line 153;
- After reception of a turn-on order, generate a specified positive voltage or current pulse between the gate G and the cathode K of the switching device T1 to ensure a current conduction of the switching device T1. The energy of the positive pulse is supplied by the positive storage capacitor C2;
- After reception of a turn-off order, generate a specified negative pulse voltage or current between the gate G and the cathode K of the switching device T1 to ensure a current blocking. The energy of the negative pulse is supplied by the negative storage capacitor C3.

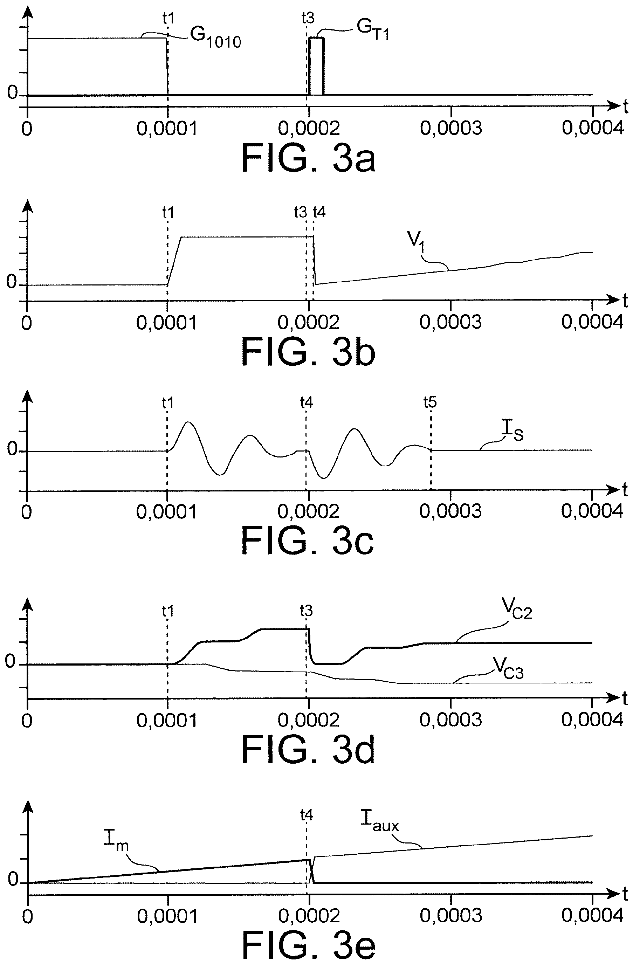

**Figures 3a-3e** show simulation results for the self-powered switch module TM of figure 2 included in the mechatronic circuit breaker device of figure 1 in performing a current commutation from the main branch 10 to the auxiliary branch 11.

**Figure 3a** shows the gate signal G₁₀₁₀ of power electronic switches 1010 in the fast breaker cells 101 and the control terminal G signal G_{T1} of the thyristors T1 in the auxiliary branch 110, as a function of time.

During a first time interval ending at time t1, the mechatronic circuit breaker device 1 is under steady condition: all power electronic switches 1010 are in ON (conducting) state and all switching devices T1 are in their OFF state.

The fast breaker cells 101 switch off at time t1, and all switching devices T1 initiate turn-on at time t3.

**Figure 3b** shows the curve of the voltage V₁ between the two terminals of the mechatronic circuit breaker device 1 as a function of time.

Under steady conditions (t < t1), the transmission line current flows through the main branch 10, which is in a low resistive state, the voltage V₁ is close to zero.

The voltage V₁ starts increasing from time t1 on at which the fast breaker cells 101 are switched off. The voltage V₁ is subsequently clamped by the surge voltage limiter 103. At time t4, when all switching devices T1 in the auxiliary sub-branch 110 are triggered ON, voltage V₁ drops suddenly to a roughly zero amplitude.

In the example where the auxiliary sub-branch 110 comprises a power capacitor module 112, the voltage V₁ increases once again starting from time t4 on and resulting in the charging of power capacitor 1120 in the power capacitor module 112. The voltage V₁ is clamped by the surge voltage limiter 1124 when the voltage across the power capacitor module 112 exceeds the clamping voltage of the surge voltage limiter 1124.

In another example where the auxiliary sub-branch 110 comprises only the self-powered switch device 111, the voltage V₁ remains roughly zero from time t4 and the amplitude of the voltage V₁ depends on the voltage drop of the self-powered switch device 111 in conduction state.

**Figure 3c** shows the curve of the current Iₛ flowing through the LCR circuit of a self-powered switch module TM in the auxiliary sub-branch 110, as a function of time.

Under steady conditions (t < t1), there is no current flowing through the LCR circuit. The current Iₛ rises from time t1 at which the fast breaker cells 101 switch off and results from a step voltage applied across each self-powered switch module TM of the auxiliary sub-branch 110. The LCR circuit's underdamped response initiates a transient oscillating current flowing through the LCR circuit and the full wave rectifier circuit 1111. The positive storage capacitor C2 and the negative storage capacitor C3 are charged up with a voltage polarization corresponding to the positive diode D2 and the negative diode D3, respectively.

At time t4, the self-powered switch module TM in the auxiliary sub-branch 110 is triggered ON, a second voltage step across the self-powered switch module TM is initiated and leads to a second transient oscillating current flowing through the LCR circuit and charging up further both the positive and the negative storage capacitors.

Due to resistive damping, the LCR circuit current Iₛ decreases down to zero at time t5.

**Figure 3d** shows the curve of the voltage V_{C2} across the positive storage capacitor C2 and of the voltage V_{C3} across the negative storage capacitor C3 in the power supply and driver device DM, as a function of time.

Under steady conditions (t < t1), the capacitors C2 and C3 are discharged by the parasitic resistances and the voltages V_{C2} and V_{C3} are close to zero. The parasitic resistances may be a property of the capacitor parts themselves or result from the quiescent current of the driver circuit in parallel with the capacitors C2 and C3.

From time t1 on, the capacitors C2 and C3 are charged up by the LCR circuit current Iₛ with their respective polarization. Before time t3, the voltage V_{C2} increases to a level able to fulfill the closing criterion of the self-powered switch module TM. At time t3, the switch monitoring and driver module M receives a turn-on order and generates subsequently a positive pulse current between the control terminal G and the cathode K of the switching device T1 by releasing the energy stored in the capacitor C2. This leads to the decrease of the voltage V_{C2} roughly to zero.

The switch monitoring and driver module M may break off the positive pulse current between the control terminal G and the cathode K after the switching device T1 has completed the conduction. The amplitude and duration of the current pulse into the control terminal G may be predefined depending on the control terminal's properties and rate of rise of anode current (di/dt) of the switching device T1.

From time t4, at which the switching device T1 fully starts conducting, the amplitudes of the voltages V_{C2} and V_{C3} continue to increase resulting from the discharge of capacitor C1 in the LCR circuit through the conducting switching device T1. The first capacitor C1 transfers subsequently its energy to the capacitors C2 and C3 with the second transiently oscillating current.

Before time t5, the voltage V_{C3} across the negative storage capacitor C3 has increased to a level able to fulfill the opening criterion of the self-powered switch module TM. The switch driver M is powered up and the self-powered switch module TM is ready for a turn-off switching.

The amplitudes of the voltages V_{C2} and V_{C3} are limited to the levels corresponding to the clamping voltages of the surge voltage limiters Z2 and Z3 respectively, which prevent any overvoltage of the capacitors C2 and C3.

**Figure 3e** shows the curves of the current Iₘ in the main branch and of the current Iₐᵤₓ in the auxiliary branch, as a function of time.

After reception of a turn-on order in the self-powered switch device 111, all the switch monitoring and driver modules M initiate simultaneously a positive current pulse at time t3. With a turn-on delay time of the switching devices T1, the self-powered switch device 111 completes the conduction and the current starts to commutate from the main branch 10 to the auxiliary branch 11 at time t4.

The commutation time is small, the current Iₘ in the main branch decreases to zero shortly after time t4 and the mechatronic circuit breaker device 1 completes the current commutation.

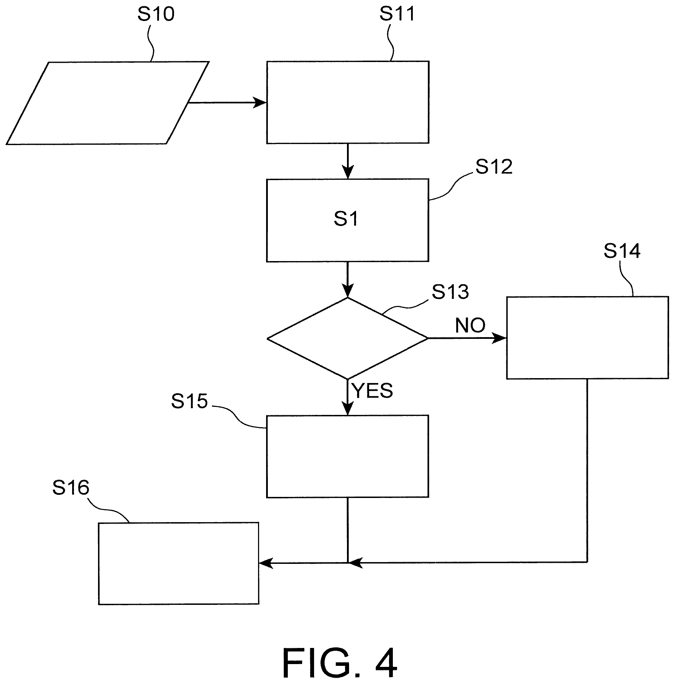

**Figure 4** shows an embodiment of the state checking of a self-powered switch module TM in the auxiliary sub-branch 110. The method comprises steps S10 to S16.

In step S10, a self-powered switch module TM checking instruction is received by the breaker controller 20 via the signal line 160. For example, the checking instruction may be issued from a network control center (not shown). The checking instruction may further be issued from the breaker controller 20 by itself. For example, the breaker controller 20 may scan the state of the self-powered switch module TM periodically when the breaker device 1 works in the conduction mode.

In following step S11, the breaker controller 20 sends an order to open the fast breaker cells 101 in the main branch. The fast breaker cells 101 are switched off with a small delay time and produce a voltage step across the mechatronic circuit breaker device 1.

In following step S12, the breaker controller 20 sends a checking order S1 to the self-powered switch module TM which is specified in the checking instruction received by the breaker controller 20.

After the reception of the checking order S1, the switch monitoring and driver module M measures the voltages across the capacitors C2 and/or C3 and sends back the information to the breaker controller 20 via the signal line 153.

In step S13, the breaker controller 20 decodes the state signal and evaluates a state criterion based on the voltage amplitude of capacitors C2 and/or C3 to determine whether the self-powered switch module TM is operational. In this example, both voltages V_{C2} and V_{C3} are no less than predetermined levels to meet the state criterion. The predetermined levels are calculated from the parameters of the components in the mechatronic circuit breaker device 1.

If the state signal from the self-powered switch module TM does not meet the state criterion, step S13 is followed by step S14 at which the breaker controller 20 updates the state data of the self-powered switch module TM as 'Failed'.

If the state signal from the self-powered switch module TM meets the state criterion, step S13 is followed by step S15 at which the breaker controller 20 updates the state data of the self-powered switch module TM as 'Correct'.

Steps S14 and S15 are followed by step S16, at which the breaker controller 20 sends an order to close the fast breaker cells 101 after the update process is completed.

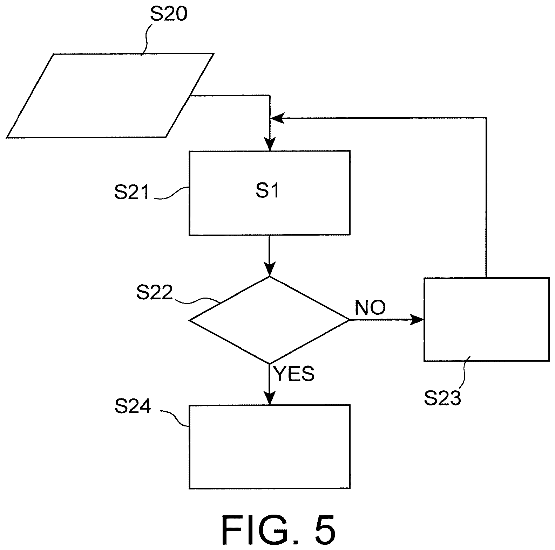

**Figure 5** shows an embodiment of a switching control method of a self-powered switch device 111 in the auxiliary branch 11. The method comprises steps S20 to S24.

In step S20, a self-powered switch device 111 switching instruction is received by the breaker controller 20 via the signal line 160. For example, the switching instruction may be issued from a network control center (not shown). The switching instruction may further be generated by the breaker controller 20 itself. For example, the breaker controller 20 may perform a current interruption which comprises the switching control of the self-powered switch device 111.

There may be two types of switching instruction received by the breaker controller 20:
- A turn-on instruction, when the self-powered switch device 111 is in a blocking state.
- A turn-off instruction, when the self-powered switch device 111 is in a conduction state.

In following step S21, the breaker controller 20 sends simultaneously a checking order S1 to each self-powered switch module TM.

After the reception of a checking order S1, each self-powered switch module TM measures the voltages across the capacitors C2 and/or C3 and sends back the information in a state signal to the breaker controller 20 via the signal line 153.

In following step S22, the breaker controller 20 decodes the state signals and evaluates a switching criterion based on the voltages of capacitor C2 or capacitor C3 to determine whether each self-powered switch module TM in the self-powered switch device 111 is ready for switching.

There are two switching criterions in this embodiment:
- Switching criterion for turn-on, where the voltage amplitude of capacitor C2 is higher than a predetermined level;
- Switching criterion for turn-off, where the voltage amplitude of capacitor C3 is higher than a predetermined level.

The predetermined levels are calculated from the parameters of the components in the circuit breaker device 1.

The switching criterion is selected corresponding to the type of switching instruction received by the breaker controller 20.

If one or more state signal(s) from the self-powered switch modules TM do(es) not meet the switching criterion, step S22 is followed by step S23 at which the breaker controller 20 updates the state data corresponding to the defective self-powered module (s) TM in its memory. Step S23 is followed by step S21.

If all the state signals from the self-powered switch module TM meet the state criterion, step S22 is followed by step S24 at which the breaker controller 20 sends simultaneously a switching order to each self-powered switch module TM.

There are two types of switching orders in this embodiment:
- Switching order for turn-on;
- Switching order for turn-off.

The type of switching order to be sent by the breaker controller 20 corresponds to the type of switching instruction received by the breaker controller 20.

## Claims

1. A self-powered switch device (111) adapted to be included in a mechatronic circuit breaker **characterized in that** it comprises at least one self-powered switch module (TM) comprising:
• a switching device (T1) having main terminals (A, K) adapted to be connected to a current path, and having a control terminal (G) receiving a switching signal to selectively operate the switching device in a conductive state or a nonconductive state for controlling the conduction of current between the main terminals;
• a power supply circuit (PS) having first and second circuit terminals respectively connected to the main terminals of the switching device (T1), a serial LCR circuit connected to the first circuit terminal, comprising an inductor (L1), a first resistor (R1) and a first capacitor (C1) and a full wave rectifier circuit (1111) connected in series with the LCR circuit and the second circuit terminal; wherein the full wave rectifier circuit (1111) comprises a first and a second diode-capacitor circuits connected in parallel, the first diode-capacitor circuit having a positive diode (D2) and a positive storage capacitor (C2) connected in series and the second diode-capacitor circuit having a negative diode (D3) and a negative storage capacitor (C3) connected in series, the positive storage capacitor (C2) and the negative storage capacitor (C3) being both connected to the second circuit terminal; and
• a switch monitoring and driver module (M) having an output connected to the control terminal (G) of the switching device, two power terminals and a common terminal for receiving power connected in parallel with the positive storage capacitor (C2) and the negative storage capacitor (C3) respectively, and a signal terminal connected to a signal line (153) to receive a control signal or send a switch state signal.

2. A self-powered switch device according to claim 1, **characterized in that** the transient response of the LCR circuit in the power supply circuit (PS) is underdamped.

3. A self-powered switch device according to claim 1 or 2, **characterized in that** the self-powered switch module (TM) comprises a first surge voltage limiter (Z1) having two terminals respectively connected to the main terminals (A, K) of the switching device (T1).

4. A self-powered switch device according to anyone of claims 1 to 3, **characterized in that** the full wave rectifier circuit (1111) comprises a second surge voltage limiter (Z2) and a third surge voltage limiter (Z3) connected in parallel with the positive storage capacitor (C2) and the negative storage capacitor (C3), respectively.

5. A self-powered switch device according to anyone of claims 1 to 4, **characterized in that** the LCR circuit comprises a second resistor (R2) connected in parallel with the first capacitor (C1).

6. A self-powered switch device according to anyone of claims 1 to 5, **characterized in that** the switch monitoring and driver module (M) is adapted to:
- provide a positive pulse of voltage or current between the control terminal (G) and one of the main terminals (K) of the switching device according to a received control signal using power from the positive storage capacitor (C2);
- provide a negative pulse of voltage or current between the control terminal (G) and one of the main terminals (K) of the switching device according to a received control signal using power from the negative storage capacitor (C3);
- send the information of voltages across the positive storage capacitor (C2) and/or the negative storage capacitor (C3) respectively, according to a received control signal.

7. A self-powered switch device according to anyone of claims 1 to 6, **characterized in that** the switching device (T1) comprises a fast thyristor comprising whose main terminals are an anode (A) and a cathode (K), and of which the turn-off time (Tq) is reduced by applying a negative pulse voltage between the control terminal (G) and the cathode (K).

8. A self-powered switch device according to anyone of claims 1 to 6, **characterized in that** the switching device (T1) comprises a Gate Turn-Off thyristor.

9. A self-powered switch device according to anyone of claims 1 to 6, **characterized in that** the switching device (T1) comprises a gas insulated switch comprising an anode and a cathode, of which the anode current interruption is achieved by applying a negative pulse voltage between the control terminal (G) and the cathode.

10. A self-powered switch device according to anyone of claims 1 to 9, **characterized in that** it comprises a plurality of self-powered switch modules (TM) connected in series.

11. A self-powered switch device according to anyone of claims 1 to 10, **characterized in that** it comprises two self-powered switch module (TM) connected in antiparallel.

12. A mechatronic circuit breaker device (1) in which is included a self-powered switch device according to anyone of claims 1 to 11, the mechatronic circuit breaker device comprising:
- a main branch (10) having an electromechanical switch disconnector (100) connected in series with two fast breaker cells (101) arranged anti-series,
- an auxiliary branch (11) connected in parallel with the main branch (10), having at least one auxiliary sub-branch (110), the auxiliary sub-branch (110) comprising the self-powered switch device (111),
- an energy absorbing branch (12) connected in parallel with the main branch (10) and the auxiliary branch (11), and having at least one surge voltage limiter (120), and
- a breaker controller (20) connected to the electromechanical switch disconnector (100), the fast breaker cells (101) and each self-powered switch module (TM) by respective signal lines, and having a memory adapted to save the state information of each self-powered switch module (TM).

13. A switching control method of a self-powered switch device according to anyone of claims 1 to 11, **characterized in that** it comprises steps of:
- sending a checking order (S21) to each self-powered switch module (TM) in the self-powered switch device (111);
- evaluating a switching criterion (S22);
- sending a switching order (S24) to each self-powered switch module (TM) in the self-powered switch device (111);
wherein the step of sending a switching order (S24) is completed after every self-powered switch module (TM) in the self-powered switch device (111) meets the switching criterion.

14. A switching control method according to claim 13, **characterized in that** a switching order comprises one of:
- a turn-on switching order when the self-powered switch device (111) is in a blocking state; and
- a turn-off switching order when the self-powered switch device (111) is in a conduction state.

15. A switching control method according to claim 14, **characterized in that** the switching criterion of a turn-on switching order comprises the voltage amplitude of the positive storage capacitor (C2) being higher than a first threshold, and the switching criterion of a turn-off switching order comprises the voltage amplitude of the negative storage capacitor (C3) being higher than a second threshold.

16. A state checking method of a self-powered switch device included in a mechatronic circuit breaker according to claim 12, **characterized in that** it comprises steps of:
- sending an order for opening the fast breaker cell (S11);
- sending a checking order (S12) to a self-powered switch module (TM);
- evaluating a state criterion for the self-powered switch module (S13);
- updating the state information (S14, S15) of the self-powered switch module (TM) in the memory of the breaker controller (20); and
- sending an order for closing the fast breaker cell (S16).

17. A switching control method according to claim 16, **characterized in that** the state criterion is evaluated using the voltage amplitude of the positive storage capacitor (C2) or the voltage amplitude of the negative storage capacitor (C3).

## Patentansprüche

1. Selbstbetriebene Schaltvorrichtung (111), die dazu angepasst ist, in einer mechatronischen Schaltungsunterbrechung beinhaltet zu sein, **dadurch gekennzeichnet, dass** sie zumindest ein selbstbetriebenes Schaltmodul (TM) umfasst, umfassend:
• eine Schaltvorrichtung (T1), die Hauptanschlüsse (A, K) aufweist, die dazu angepasst sind, mit einem Strompfad verbunden zu werden, und einen Steueranschluss (G) aufweist, der ein Schaltsignal empfängt, um selektiv die Schaltvorrichtung in einem leitenden Zustand oder einem nicht-leitenden Zustand zu betreiben, um die Leitung von Strom zwischen den Hauptanschlüssen zu steuern;
• eine Leistungsversorgungsschaltung (PS), die einen ersten beziehungsweise zweiten Schaltungsanschluss, die mit den Hauptanschlüssen der Schaltvorrichtung (T1) verbunden sind, eine serielle LCR-Schaltung, die mit dem ersten Schaltungsanschluss verbunden ist, umfassend einen Induktor (L1), einen ersten Widerstand (R1) und einen ersten Kondensator (C1), und eine Vollwellengleichrichterschaltung (1111), die in Reihe mit der LCR-Schaltung und dem zweiten Schaltungsanschluss verbunden ist, aufweist; wobei die Vollwellengleichrichterschaltung (1111) eine erste und eine zweite Dioden-Kondensator-Schaltung parallel verbunden umfasst, wobei die erste Dioden-Kondensator-Schaltung eine positive Diode (D2) und einen positiven Speicherkondensator (C2) in Reihe verbunden aufweist und die zweite Dioden-Kondensator-Schaltung eine negative Diode (D3) und einen negativen Speicherkondensator (C3) in Reihe verbunden aufweist, wobei sowohl der positive Speicherkondensator (C2) als auch der negative Speicherkondensator (C3) mit dem zweiten Schaltungsanschluss verbunden sind; und
• ein Schaltüberwachungs- und Treibermodul (M), das einen Ausgang, der mit dem Steueranschluss (G) der Schaltvorrichtung verbunden ist, zwei Leistungsanschlüsse und einen gemeinsamen Anschluss zum Empfangen von Leistung parallel mit dem positiven Speicherkondensator (C2) beziehungsweise dem negativen Speicherkondensator (C3) verbunden, und einen Signalanschluss mit einer Signalleitung (153) verbunden, um ein Steuersignal zu empfangen oder ein Schaltzustandssignal zu senden, aufweist.

2. Selbstbetriebene Schaltvorrichtung nach Anspruch 1, **dadurch gekennzeichnet, dass** die vorübergehende Reaktion der LCR-Schaltung in der Leistungsversorgungsschaltung (PS) unterdämpft ist.

3. Selbstbetriebene Schaltvorrichtung nach Anspruch 1 oder 2, **dadurch gekennzeichnet, dass** das selbstbetriebene Schaltmodul (TM) einen ersten Stoßspannungsbegrenzer (Z1) umfasst, der zwei Anschlüsse jeweils mit den Hauptanschlüssen (A, K) der Schaltvorrichtung (T1) verbunden aufweist.

4. Selbstbetriebene Schaltvorrichtung nach einem der Ansprüche 1 bis 3, **dadurch gekennzeichnet, dass** die Vollwellengleichrichterschaltung (1111) einen zweiten Stoßspannungsbegrenzer (Z2) und einen dritten Stoßspannungsbegrenzer (Z3) parallel mit dem positiven Speicherkondensator (C2) beziehungsweise dem negativen Speicherkondensator (C3) verbunden umfasst.

5. Selbstbetriebene Schaltvorrichtung nach einem der Ansprüche 1 bis 4, **dadurch gekennzeichnet, dass** die LCR-Schaltung einen zweiten Widerstand (R2) parallel mit dem ersten Kondensator (C1) verbunden umfasst.

6. Selbstbetriebene Schaltvorrichtung nach einem der Ansprüche 1 bis 5, **dadurch gekennzeichnet, dass** das Schaltüberwachungs- und Treibermodul (M) für Folgendes angepasst ist:
- Bereitstellen eines positiven Spannungspulses oder Stroms zwischen dem Steueranschluss (G) und einem der Hauptanschlüsse (K) der Schaltvorrichtung gemäß einem empfangenen Steuersignal unter Verwendung von Leistung von dem positiven Speicherkondensator (C2);
- Bereitstellen eines negativen Spannungspulses oder Stroms zwischen dem Steueranschluss (G) und einem der Hauptanschlüsse (K) der Schaltvorrichtung gemäß einem empfangenen Steuersignal unter Verwendung von Leistung von dem negativen Speicherkondensator (C3);
- Senden der Informationen zu Spannungen jeweils über den positiven Speicherkondensator (C2) und/oder den negativen Speicherkondensator (C3) gemäß einem empfangenen Steuersignal.

7. Selbstbetriebene Schaltvorrichtung nach einem der Ansprüche 1 bis 6, **dadurch gekennzeichnet, dass** die Schaltvorrichtung (T1) einen schnellen Thyristor umfasst, umfassend, dass dessen Hauptanschlüsse eine Anode (A) und eine Kathode (K) sind und dessen Ausschaltzeit (Tq) reduziert wird, indem eine negative Pulsspannung zwischen dem Steueranschluss (G) und der Kathode (K) angelegt wird.

8. Selbstbetriebene Schaltvorrichtung nach einem der Ansprüche 1 bis 6, **dadurch gekennzeichnet, dass** die Schaltvorrichtung (T1) einen Gate-Ausschalt-Thyristor umfasst.

9. Selbstbetriebene Schaltvorrichtung nach einem der Ansprüche 1 bis 6, **dadurch gekennzeichnet, dass** die Schaltvorrichtung (T1) einen gasisolierten Schalter umfasst, der eine Anode und eine Kathode umfasst, dessen Anodenstromunterbrechung erreicht wird, indem eine negative Pulsspannung zwischen dem Steueranschluss (G) und der Kathode angelegt wird.

10. Selbstbetriebene Schaltvorrichtung nach einem der Ansprüche 1 bis 9, **dadurch gekennzeichnet, dass** sie eine Vielzahl von selbstbetriebenen Schaltmodulen (TM) in Reihe verbunden umfasst.

11. Selbstbetriebene Schaltvorrichtung nach einem der Ansprüche 1 bis 10, **dadurch gekennzeichnet, dass** sie zwei selbstbetriebene Schaltmodule (TM) antiparallel verbunden umfasst.

12. Mechatronische Schaltungsunterbrechungsvorrichtung (1), in der eine selbstbetriebene Schaltvorrichtung nach einem der Ansprüche 1 bis 11 beinhaltet ist, wobei die mechatronische Schaltungsunterbrechungsvorrichtung Folgendes umfasst:
- eine Hauptabzweigung (10), die einen elektromechanischen Schaltertrenner (100) aufweist, der in Reihe mit zwei schnellen Unterbrechungszellen (101) verbunden ist, die in Anti-Reihe eingerichtet sind,
- eine Hilfsabzweigung (11), die parallel mit der Hauptabzweigung (10) verbunden ist, wobei sie zumindest eine Hilfsteilabzweigung (110) aufweist, wobei die Hilfsteilabzweigung (110) die selbstbetriebene Schaltvorrichtung (111) umfasst, - eine energieabsorbierende Abzweigung (12), die parallel mit der Hauptabzweigung (10) und der Hilfsabzweigung (11) verbunden ist und zumindest einen Stoßspannungsbegrenzer (120) aufweist, und
- eine Unterbrechungssteuerung (20), die mit dem elektromechanischen Schaltertrenner (100), den schnellen Unterbrechungszellen (101) und jedem selbstbetriebenen Schaltmodul (TM) durch jeweilige Signalleitungen verbunden ist und einen Speicher aufweist, der dazu angepasst ist, die Zustandsinformationen jedes selbstbetriebenen Schaltmoduls (TM) zu speichern.

13. Schaltsteuerungsverfahren einer selbstbetriebenen Schaltvorrichtung nach einem der Ansprüche 1 bis 11, **dadurch gekennzeichnet, dass** es die folgenden Schritte umfasst:
- Senden eines Prüfbefehls (S21) an jedes selbstbetriebene Schaltmodul (TM) in der selbstbetriebenen Schaltvorrichtung (111);
- Evaluieren eines Schaltkriteriums (S22);
- Senden eines Schaltbefehls (S24) an jedes selbstbetriebene Schaltmodul (TM) in der selbstbetriebenen Schaltvorrichtung (111);
wobei der Schritt vom Senden eines Schaltbefehls (S24) abgeschlossen ist, nachdem jedes selbstbetriebene Schaltmodul (TM) in der selbstbetriebenen Schaltvorrichtung (111) das Schaltkriterium erfüllt.

14. Schaltsteuerungsverfahren nach Anspruch 13, **dadurch gekennzeichnet, dass** ein Schaltbefehl einen des Folgenden umfasst:
- einen Einschalt-Schaltbefehl, wenn die selbstbetriebene Schaltvorrichtung (111) in einem blockierenden Zustand ist; und
- einen Ausschalt-Schaltbefehl, wenn die selbstbetriebene Schaltvorrichtung (111) in einem Leitungszustand ist.

15. Schaltsteuerungsverfahren nach Anspruch 14, **dadurch gekennzeichnet, dass** das Schaltkriterium eines Einschalt-Schaltbefehls umfasst, dass die Spannungsamplitude des positiven Speicherkondensators (C2) höher als eine erste Schwelle ist und das Schaltkriterium eines Ausschalt-Schaltbefehls umfasst, dass die Spannungsamplitude des negativen Speicherkondensators (C3) höher als eine zweite Schwelle ist.

16. Zustandsprüfverfahren einer selbstbetriebenen Schaltvorrichtung, die in einer mechatronischen Schaltungsunterbrechung nach Anspruch 12 beinhaltet ist, **dadurch gekennzeichnet, dass** es die folgenden Schritte umfasst:
- Senden eines Befehls zur Öffnung der schnellen Unterbrechungszelle (S11);
- Senden eines Prüfbefehls (S12) an ein selbstbetriebenes Schaltmodul (TM);
- Evaluieren eines Zustandskriteriums für das selbstbetriebene Schaltmodul (S13);
- Aktualisieren der Zustandsinformationen (S14, S15) des selbstbetriebenen Schaltmoduls (TM) in dem Speicher der Unterbrechungssteuerung (20); und
- Senden eines Befehls zum Schließen der schnellen Unterbrechungszelle (S16).

17. Schaltsteuerungsverfahren nach Anspruch 16, **dadurch gekennzeichnet, dass** das Zustandskriterium unter Verwendung der Spannungsamplitude des positiven Speicherkondensators (C2) oder der Spannungsamplitude des negativen Speicherkondensators (C3) evaluiert wird.

## Revendications

1. Dispositif de commutation autoalimenté (111) adapté pour être inclus dans un disjoncteur mécatronique **caractérisé en ce qu'**il comprend au moins un module de commutation autoalimenté (TM) comprenant :
• un dispositif de commutation (T1) présentant des bornes principales (A, K) adaptées pour être raccordées à un trajet de courant, et présentant une borne de commande (G) recevant un signal de commutation pour faire fonctionner sélectivement le dispositif de commutation dans un état conducteur ou un état non conducteur pour commander la conduction de courant entre les bornes principales ;
• un circuit d'alimentation électrique (PS) présentant des première et seconde bornes de circuit respectivement raccordées aux bornes principales du dispositif de commutation (T1), un circuit RLC série raccordé à la première borne de circuit, comprenant une bobine d'induction (L1), une première résistance (R1) et un premier condensateur (C1) et un circuit redresseur pleine onde (1111) raccordé en série au circuit RLC et à la seconde borne de circuit ; dans lequel le circuit redresseur pleine onde (1111) comprend un premier et un second circuits diode-condensateur raccordés en parallèle, le premier circuit diode-condensateur présentant une diode positive (D2) et un condensateur de stockage positif (C2) raccordé en série et le second circuit diode-condensateur présentant une diode négative (D3) et un condensateur de stockage négatif (C3) raccordés en série, le condensateur de stockage positif (C2) et le condensateur de stockage négatif (C3) étant tous deux raccordés à la seconde borne de circuit ; et
• un module de surveillance et de pilotage de commutateur (M) présentant une sortie raccordée à la borne de commande (G) du dispositif de commutation, deux bornes d'alimentation et une borne commune pour recevoir de l'alimentation raccordées en parallèle avec le condensateur de stockage positif (C2) et le condensateur de stockage négatif (C3) respectivement, et une borne de signal raccordée à une ligne de signal (153) pour recevoir un signal de commande ou envoyer un signal d'état de commutateur.

2. Dispositif de commutation autoalimenté selon la revendication 1, **caractérisé en ce que** la réponse transitoire du circuit RLC dans le circuit d'alimentation électrique (PS) est sous-amortie.

3. Dispositif de commutation autoalimenté selon la revendication 1 ou 2, **caractérisé en ce que** le module de commutation autoalimenté (TM) comprend un premier limiteur de surtension (Z1) présentant deux bornes respectivement raccordées aux bornes principales (A, K) du dispositif de commutation (T1).

4. Dispositif de commutation autoalimenté selon l'une quelconque des revendications 1 à 3, **caractérisé en ce que** le circuit redresseur pleine onde (1111) comprend un deuxième limiteur de surtension (Z2) et un troisième limiteur de surtension (Z3) raccordés en parallèle au condensateur de stockage positif (C2) et au condensateur de stockage négatif (C3), respectivement.

5. Dispositif de commutation autoalimenté selon l'une quelconque des revendications 1 à 4, **caractérisé en ce que** le circuit RLC comprend une seconde résistance (R2) raccordée en parallèle au premier condensateur (C1).

6. Dispositif de commutation autoalimenté selon l'une quelconque des revendications 1 à 5, **caractérisé en ce que** le module de surveillance et de pilotage de commutateur (M) est adapté pour :
- fournir une impulsion positive de tension ou de courant entre la borne de commande (G) et une des bornes principales (K) du dispositif de commutation selon un signal de commande reçu utilisant de l'alimentation depuis le condensateur de stockage positif (C2) ;
- fournir une impulsion négative de tension ou de courant entre la borne de commande (G) et une des bornes principales (K) du dispositif de commutation selon un signal de commande reçu utilisant de l'alimentation depuis le condensateur de stockage négatif (C3) ;
- envoyer les informations de tensions sur le condensateur de stockage positif (C2) et/ou le condensateur de stockage négatif (C3) respectivement, selon un signal de commande reçu.

7. Dispositif de commutation autoalimenté selon l'une quelconque des revendications 1 à 6, **caractérisé en ce que** le dispositif de commutation (T1) comprend un thyristor rapide comprenant dont les bornes principales sont une anode (A) et une cathode (K), et dans lequel le temps d'arrêt (Tq) est réduit en appliquant une tension d'impulsion négative entre la borne de commande (G) et la cathode (K).

8. Dispositif de commutation autoalimenté selon l'une quelconque des revendications 1 à 6, **caractérisé en ce que** le dispositif de commutation (T1) comprend un thyristor à extinction par la gâchette.

9. Dispositif de commutation autoalimenté selon l'une quelconque des revendications 1 à 6, **caractérisé en ce que** le dispositif de commutation (T1) comprend un commutateur isolé au gaz comprenant une anode et une cathode, dont l'interruption de courant d'anode est atteinte en appliquant une tension d'impulsion négative entre la borne de commande (G) et la cathode.

10. Dispositif de commutation autoalimenté selon l'une quelconque des revendications 1 à 9, **caractérisé en ce qu'**il comprend une pluralité de modules de commutation autoalimentés (TM) raccordés en série.

11. Dispositif de commutation autoalimenté selon l'une quelconque des revendications 1 à 10, **caractérisé en ce qu'**il comprend deux modules de commutation autoalimentés (TM) raccordés en antiparallèle.

12. Dispositif de disjoncteur mécatronique (1) dans lequel est inclus un dispositif de commutation autoalimenté selon l'une quelconque des revendications 1 à 11, le dispositif de disjoncteur mécatronique comprenant :
- une branche principale (10) présentant un sectionneur de commutation électromécanique (100) raccordé en série avec deux cellules de disjoncteur rapides (101) agencées en antisérie,
- une branche auxiliaire (11) raccordée en parallèlle à la branche principale (10), présentant au moins une sous-branche auxiliaire (110), la sous-branche auxiliaire (110) comprenant le dispositif de commutation autoalimenté (111), - une branche d'absorption d'énergie (12) raccordée en parallèle à la branche principale (10) et à la branche auxiliaire (11), et présentant au moins un limiteur de surtension (120), et
- un dispositif de commande de disjoncteur (20) raccordé au sectionneur de commutation électromécanique (100), aux cellules de disjoncteur rapides (101) et à chaque module de commutation autoalimenté (TM) par des lignes de signal respectives, et présentant une mémoire adaptée pour sauvegarder les informations d'état de chaque module de commutation autoalimenté (TM).

13. Procédé de commande de commutation d'un dispositif de commutation autoalimenté selon l'une quelconque des revendications 1 à 11, **caractérisé en ce qu'**il comprend les étapes consistant à :
- envoyer un ordre de vérification (S21) à chaque module de commutation autoalimenté (TM) dans le dispositif de commutation autoalimenté (111) ;
- évaluter un critère de commutation (S22) ;
- envoyer un ordre de commutation (S24) à chaque module de commutation autoalimenté (TM) dans le dispositif de commutation autoalimenté (111) ;
dans lequel l'étape consistant à envoyer un ordre de commutation (S24) est terminée après que chaque module de commutation autoalimenté (TM) dans le dispositif de commutation autoalimenté (111) satisfait au critère de commutation.

14. Procédé de commande de commutation selon la revendication 13, **caractérisé en ce qu'**un ordre de commutation comprend un parmi :
- un ordre de commutation de marche lorsque le dispositif de commutation autoalimenté (111) est dans un état de blocage ; et
- un ordre de commutation d'arrêt lorsque le dispositif de commutation autoalimenté (111) est dans un état de conduction.

15. Procédé de commande de commutation selon la revendication 14, **caractérisé en ce que** le critère de commutation d'un ordre de commutation de marche comprend l'amplitude de tension du condensateur de stockage positif (C2) étant supérieure à un premier seuil, et le critère de commutation d'un ordre de commutation d'arrêt comprend l'amplitude de tension du condensateur de stockage négatif (C3) étant supérieure à un second seuil.

16. Procédé de vérification d'état d'un dispositif de commutation autoalimenté inclus dans un disjoncteur mécatronique selon la revendication 12, **caractérisé en ce qu'**il comprend les étapes consistant à :
- envoyer un ordre pour ouvrir la cellule de disjoncteur rapide (S11) ;
- envoyer un ordre de vérification (S12) à un module de commutation autoalimenté (TM) ;
- évaluer un critère d'état pour le module de commutation autoalimenté (S13) ;
- mettre à jour les informations d'état (S14, S15) du module de commutation autoalimenté (TM) dans la mémoire du dispositif de commande de disjoncteur (20) ; et
- envoyer un ordre pour fermer la cellule de disjoncteur rapide (S16).

17. Procédé de commande de commutation selon la revendication 16, **caractérisé en ce que** le critère d'état est évalué en utilisant l'amplitude de tension du condensateur de stockage positif (C2) ou l'amplitude de tension du condensateur de stockage négatif (C3).
